# DEMANDE DE BREVET EUROPEEN

(11) **EP 3 979 334 A1**
(43) Date de publication de la demande: **06.04.2022**
(21) Numéro de dépôt: 21186915.1
(22) Date de dépôt: 21.07.2021
(51) Int. Cl.: H01L 31/048, H01L 31/05

(54) **ENCAPSULATION POUR MODULE SOLAIRE A ELEMENTS DE CONNEXION INTEGRES**

(30) Priorité: 30.09.2020 FR 2009955
(71) Demandeur: Commissariat à l'énergie atomique et aux énergies alternatives, 75015 Paris (FR)
(72) Inventeur: BARTH, Vincent, 38054 GRENOBLE CEDEX 09 (FR); DERRIER, Aude, 38054 GRENOBLE CEDEX 09 (FR); EYMARD, Julien, 38054 GRENOBLE CEDEX 09 (FR)
(74) Mandataire: Brevalex

(57) **Abrégé**

Procédé de fabrication d'un module photovoltaïque comprenant :
- placement d'une couche d'encapsulation (20, 40) à base d'au moins un matériau polymère d'encapsulation en contact avec les faces inférieures respectives ou les faces supérieures respectives de la première cellule photovoltaïque () et de ladite deuxième cellule photovoltaïque () juxtaposées, la couche d'encapsulation étant formée d'au moins un matériau d'encapsulation polymère intégrant une ou plusieurs pistes conductrices (25, 25a, 25b, 25c),
- lamination à chaud d'un empilement comprenant ladite première cellule photovoltaïque (C₂₀) et de la deuxième cellule photovoltaïque (C₃₀) juxtaposées recouvertes par ladite couche d'encapsulation (20, 40), de sorte à faire fondre au moins partiellement ledit matériau polymère d'encapsulation et ledit matériau conducteur et réaliser une connexion entre la première cellule et la deuxième cellule par l'intermédiaire desdites pistes conductrices tout en réalisant une encapsulation de ladite première cellule et de ladite deuxième cellule.

## Description

La présente demande se rapporte au domaine des modules photovoltaïques (également appelés « modules solaires ») qui comportent un ensemble de cellules photovoltaïques (également appelés « cellules solaires ») reliées entre elles électriquement.

L'invention concerne un procédé de fabrication amélioré d'un module photovoltaïque ainsi qu'un module obtenu à l'aide d'un tel procédé. Elle vise plus spécifiquement un procédé de réalisation d'un module pourvu d'une structure améliorée, permettant à la fois l'interconnexion et l'encapsulation de cellules ainsi qu'un module photovoltaïque comprenant une telle structure.

### ÉTAT DE LA TECHNIQUE ANTÉRIEURE

Afin de préserver les cellules photovoltaïques d'un module photovoltaïque, il est généralement prévu de les encapsuler. L'encapsulation des cellules photovoltaïques permet de les protéger de l'environnement extérieur, en particulier des intempéries, de l'humidité, de radiations par exemple de rayonnement ultra-violets.

Pour cela, il est connu de former un empilement comportant successivement: un élément de protection inférieur, typiquement en verre ou polymère, qui est disposé du côté de la face arrière des cellules et qui est typiquement sous forme d'une plaque de verre, une première couche d'encapsulation, typiquement une couche en polymère tel que par exemple de l'éthylène-acétate de vinyle (EVA), des cellules photovoltaïques reliées électriquement entre elles, une deuxième couche d'encapsulation, typiquement à base du même matériau que la première couche d'encapsulation, ainsi qu'un élément de protection supérieur transparent, qui est disposé du côté de la face avant des cellules solaires, autrement dit de la face destinée à recevoir le rayonnement solaire. L'élément de protection supérieur est typiquement sous forme d'une plaque de verre.

L'empilement est ensuite laminé à chaud de sorte à faire fondre le matériau des couches d'encapsulation, d'où il résulte la formation d'une enveloppe d'encapsulation solide des cellules photovoltaïques collée aux éléments de protection supérieur et inférieur.

Par ailleurs, dans un module photovoltaïque, les cellules photovoltaïques peuvent être connectées en série au moyen d'un élément électriquement conducteur qui relie typiquement la face supérieure d'une cellule à la face inférieure de la cellule adjacente.

Dans un tel module, la face supérieure des différentes cellules est située d'un même côté correspondant à celui de la face avant du module, et la face inférieure des différentes cellules est située du côté opposé correspondant à la face arrière du module.

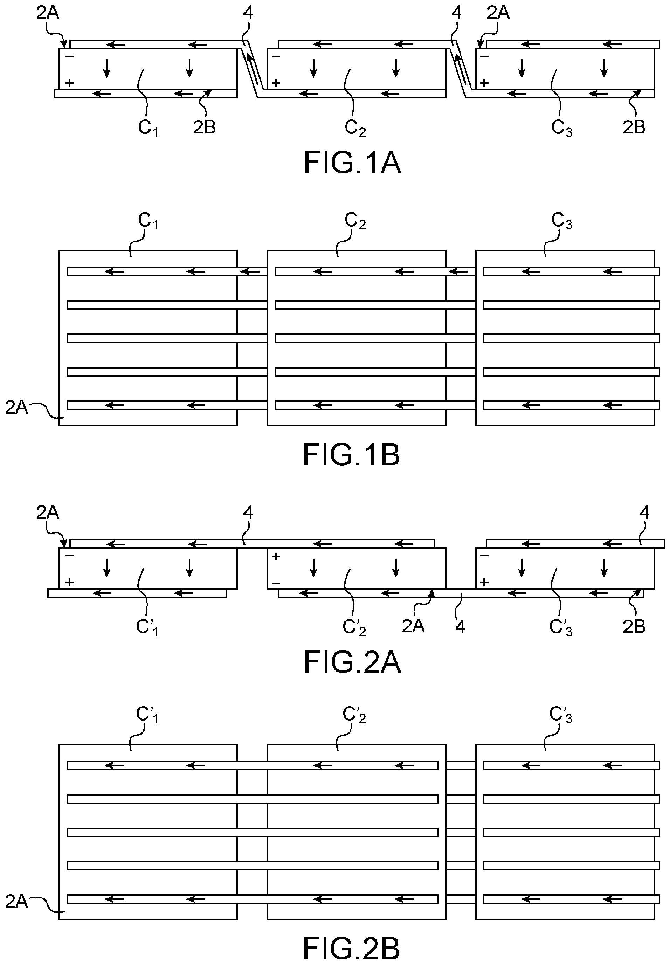

Les figures 1A et 1B illustrent un tel mode d'interconnexion (avec une vue partielle et en coupe transversale sur la figure 1A et une vue de dessus sur la figure 1B) d'un module comprenant des cellules C1, C2, C3 photovoltaïques. Pour relier la face avant 2A d'une première cellule C1 à la face arrière 2B d'une deuxième cellule C2, un ruban conducteur 4, par exemple en cuivre est prévu. Ce mode d'interconnexion s'applique aussi bien aux cellules dites mono-faciales (c'est-à-dire dont une seule des faces principales est photo-active) qu'aux cellules bifaciales (dont les deux faces, avant et arrière, sont photo-actives). La traversée du ruban conducteur 2 de la face avant 2A vers la face arrière 2B nécessite ici une déformation du ruban conducteur 4, ce qui complique la réalisation de la structure de connexion.

Un autre mode d'interconnexion dit « monolithique » est illustré sur les figures 2A-2B.

Dans ce mode d'interconnexion, on utilise un ruban de cuivre rectiligne et non-déformé pour relier respectivement une première cellule C'1 à une deuxième cellule C'2 adjacente.

Pour permettre un tel mode d'interconnexion, le module intègre généralement des cellules C'₁, C'₂, C'₃ photovoltaïques, à deux faces actives avant 2A et arrière 2B, et pouvant constituer alternativement la face avant ou la face arrière du module.

Par rapport au précédent, un tel mode d'interconnexion présente pour avantage de permettre de réduire le nombre d'étapes nécessaires à la réalisation de l'interconnexion et de rendre plus rapide cette réalisation.

Un autre avantage de l'interconnexion monolithique est qu'elle minimise les contraintes mécaniques exercées sur le ruban conducteur 4 et donc les risques de défaillances liées à ce ruban.

Encore un autre avantage de l'interconnexion monolithique est qu'elle permet de minimiser l'espacement entre les cellules C'₁, C'₂, C'₃ et par conséquent d'obtenir un rendement surfacique du module qui est augmenté.

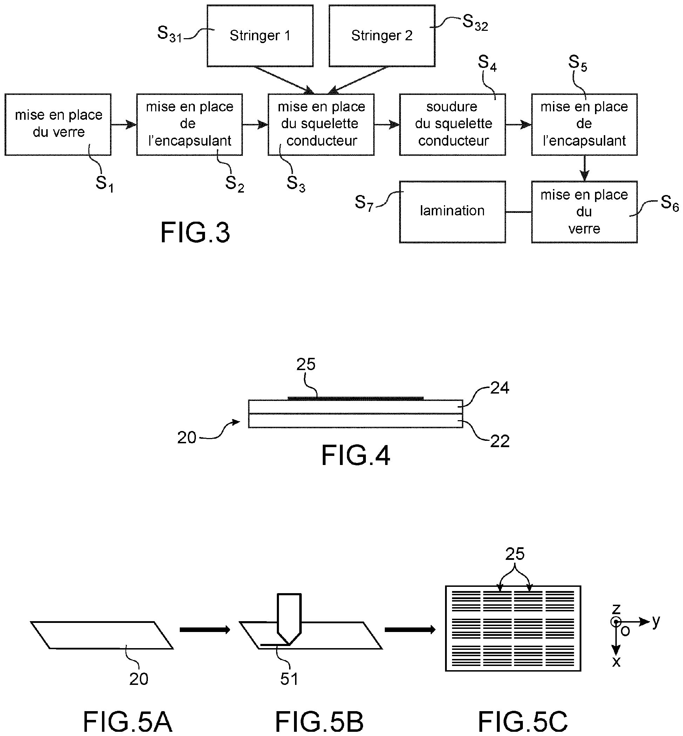

Un enchainement d'étapes d'un procédé conventionnel de fabrication d'un module photovoltaïque est donné sur la figure 3.

On dispose tout d'abord l'élément de protection inférieur en verre (étape S1).

Ensuite, on dépose sur cet élément une couche d'encapsulation (étape S2).

Puis, on met en place une structure d'interconnexion (étape S3) sur des cellules solaires juxtaposées. Cette structure d'interconnexion également appelée « squelette conducteur » est typiquement réalisée en plusieurs sous-étapes (S31 : « stringer1 », S32 : « stringer2 »), chacune utilisant un appareil communément appelé « stringer » prévu pour placer les rubans conducteurs.

Durant de telles étapes, une pluralité de rubans conducteurs sont connectés aux cellules par exemple de la manière décrite précédemment en lien avec les figures 2A-2B.

Ensuite, on effectue une soudure du squelette conducteur (étape S4) sur les cellules.

Puis, on met en place une autre couche d'encapsulation (étape S5).

Ensuite, un élément de protection supérieur en verre est disposé sur cette autre couche d'encapsulation (étape S6).

On effectue alors une lamination (anglicisme couramment utilisé et équivalent au terme « laminage », le terme lamination étant utilisé tout au long de la présente descrption) à chaud de l'empilement (étape S7).

L'appareil (« stringer ») permettant de réaliser le squelette conducteur peut s'avérer coûteux et encombrant dans une ligne de production. Par ailleurs, une telle étape qui nécessite généralement la réalisation de soudures peut s'avérer consommatrice de temps dans le cycle de fabrication.

Il se pose le problème de trouver un nouveau procédé de fabrication d'un module photovoltaïque qui soit amélioré vis-à-vis d'inconvénients mentionnés ci-dessus.

### EXPOSÉ DE L'INVENTION

Selon un aspect, la présente invention concerne un procédé de fabrication de fabrication d'un module photovoltaïque, comprenant au moins une première cellule photovoltaïque et au moins une deuxième cellule photovoltaïque chacune dotée d'une face inférieure et d'une face supérieure opposée à la face inférieure, la première cellule et la deuxième cellule étant connectées entre elles et disposées entre un premier élément de protection, en particulier une première plaque, formant une face arrière du module photovoltaïque, et un deuxième élément de protection, en particulier une deuxième plaque, transparent(e) et formant une face avant du module photovoltaïque, le procédé comprenant des étapes de :
- placement d'une couche d'encapsulation à base d'au moins un matériau polymère d'encapsulation en contact avec les faces inférieures respectives ou les faces supérieures respectives de la première cellule photovoltaïque et de ladite deuxième cellule photovoltaïque juxtaposées, la couche d'encapsulation étant formée d'au moins un matériau d'encapsulation polymère intégrant une ou plusieurs pistes conductrices à base d'au moins un matériau conducteur donné, lesdites pistes conductrices étant agencés sur des régions conductrices respectivement de la première cellule et de la deuxième cellule,
- lamination (i.e. laminage) à chaud entre le premier élément et le deuxième élément, d'un empilement comprenant ladite première cellule photovoltaïque et ladite deuxième cellule photovoltaïque juxtaposées recouvertes par ladite couche d'encapsulation, de sorte à faire fondre au moins partiellement ledit matériau polymère d'encapsulation et ledit matériau conducteur donné et réaliser un enrobage de ladite première cellule et de ladite deuxième cellule par ledit matériau polymère d'encapsulation tout en réalisant une connexion entre la première cellule et la deuxième cellule par l'intermédiaire desdites pistes conductrices.

Avec un tel procédé, le nombre d'étapes est réduit dans la mesure où l'interconnexion des cellules et l'encapsulation de l'ensemble de cellules sont réalisées de manière concomitante.

Avec un tel procédé on peut également se passer d'un certain type d'équipement appelé « stringer » et qui est habituellement utilisé pour réaliser l'interconnexion des cellules.

Un tel procédé permet également d'améliorer le débit d'une chaine de production, de diminuer le nombre d'étapes de manipulation des cellules susceptibles d'être à l'origine de casses, de réduire le coût de fabrication des modules, de réduire l'empreinte au sol de l'ensemble des appareils nécessaires à la fabrication d'un module.

Avantageusement, les pistes conductrices sont à base d'un matériau conducteur donné ou comportent un matériau conducteur donné ayant une température de fusion inférieure à une température à laquelle la lamination à chaud est effectuée.

La température à laquelle la lamination à chaud est effectuée peut être comprise entre 120 et 180°C, de préférence entre 140 et 170°C.

Avantageusement, les pistes conductrices comportent une enveloppe à base dudit matériau conducteur donné et un cœur à base d'un autre matériau conducteur ayant une température de fusion supérieure à celle à laquelle la lamination à chaud est effectuée.

Selon une possibilité de mise en œuvre, la couche d'encapsulation peut être une première couche d'encapsulation disposée sur la face inférieure desdites première cellule et deuxième cellule, le procédé peut alors comprendre en outre, préalablement à l'étape de lamination : la formation, sur la face supérieure de la première cellule photovoltaïque et de la deuxième cellule photovoltaïque juxtaposées, d'une deuxième couche d'encapsulation munie d'autres pistes conductrices intégrées.

Dans ce cas, l'étape de lamination à chaud peut être réalisée de sorte à faire fondre en outre concomitamment la deuxième couche d'encapsulation et effectuer une connexion entre la face supérieure de la première cellule et la face supérieure de la deuxième cellule par l'intermédiaire des autres pistes conductrices.

Avantageusement, la couche d'encapsulation peut être dotée d'au moins un polymère ayant des propriétés adhésives, tel que du PE ou du TPU. Un tel polymère peut permettre de favoriser l'adhésion des pistes conductrices lorsque celles-ci-sont rapportées sur la couche d'encapsulation et/ou favoriser le maintien solidaire de l'empilement.

Selon une possibilité de mise en œuvre, la couche d'encapsulation peut être formée d'au moins un autre matériau polymère choisi parmi les polymères suivants : EVA (éthylène-acétate de vinyle), silicone, TPO, POE, ou à base d'un ionomère.

Selon un mode de réalisation particulier la couche d'encapsulation peut être pourvue d'au moins une première marque d'alignement. Une telle marque d'alignement encore appelée repère d'alignement peut servir à un dispositif de type préhension et placement (« pick and place » selon la terminologie anglo-saxonne) de réaliser un alignement précis entre couche d'encapsulation à pistes intégrées et l'ensemble de cellules que l'on souhaite interconnecter.

Selon une possibilité de mise en œuvre pour laquelle le procédé comprend le placement d'une deuxième couche d'encapsulation disposée sur la face supérieure de la première cellule photovoltaïque et de la deuxième cellule photovoltaïque, la deuxième couche d'encapsulation peut également comporter une marque d'alignement dite « deuxième marque d'alignement ».

Dans ce cas, le placement de la deuxième couche d'encapsulation peut être effectué par un dispositif de préhension et placement muni d'un élément de détection tel qu'une caméra, pour détecter la première marque d'alignement et disposer la deuxième marque d'alignement en regard de la première marque d'alignement.

Selon un mode avantageux de réalisation, la ou les pistes conductrices de la couche d'encapsulation peuvent être des pistes réalisées par impression d'encre conductrice.

Selon une possibilité de mise en œuvre, le procédé de réalisation du module peut comprendre en outre préalablement au placement de la couche d'encapsulation : la fabrication de la couche d'encapsulation, cette fabrication comprenant au moins une étape de dépôt de fils ou rubans conducteurs ou d'impression de lignes d'encre conductrice sur une couche du matériau polymère d'encapsulation pour réaliser les pistes conductrices.

Selon une possibilité de mise en œuvre, cette fabrication de la couche d'encapsulation peut comprendre une étape de séparation par poinçonnement de portions desdites fils conducteurs ou rubans conducteurs ou lignes conductrices.

Avantageusement, les faces inférieure et supérieure de la première cellule photovoltaïque ont des polarités opposées à celles respectivement de la face inférieure et de la face supérieure de ladite deuxième cellule photovoltaïque.

### BRÈVE DESCRIPTION DES DESSINS

La présente invention sera mieux comprise à la lecture de la description d'exemples de réalisation donnés, à titre purement indicatif et nullement limitatif, en faisant référence aux dessins annexés sur lesquels:
Les figures 1A, 1B servent à illustrer une technique conventionnelle d'interconnexion de cellules photovoltaïques d'un module photovoltaïque ;
Les figures 2A, 2B servent à illustrer une autre technique conventionnelle dite « monolithique » pour connecter entre elles des cellules photovoltaïques d'un module photovoltaïque ;
La figure 3 sert à illustrer un enchainement conventionnel d'étapes de réalisation d'un module photovoltaïque ;
La figure 4 sert à illustrer une couche d'encapsulation à pistes conductrices intégrées pour l'interconnexion et l'encapsulation de cellules d'un module photovoltaïque tel que mis en œuvre suivant un mode de réalisation de la présente invention ;
Les figures 5A, 5B, 5C servent à illustrer différentes étapes d'un procédé de réalisation d'une couche d'encapsulation pourvue de pistes conductrices permettant de réaliser concomitamment l'encapsulation et l'interconnexion de cellules photovoltaïques d'un module photovoltaïque ;
Les figures 6A, 6B servent à illustrer un mode de réalisation particulier d'un procédé de réalisation d'une couche d'encapsulation pourvue de pistes conductrices ;
Les figures 7A, 7B, 7C, 7D, 7E, 7F servent à illustrer un mode de réalisation particulier d'un procédé, suivant l'invention, de fabrication d'un module photovoltaïque ;
La figure 8 sert à illustrer un enchainement d'étapes de réalisation d'un module photovoltaïque tel que mis en œuvre suivant un mode de réalisation de la présente invention ;
Les figures 9A, 9B servent à illustrer une technique particulière d'alignement des pistes conductrices de la couche d'encapsulation avec les cellules que cette couche est amenée à enrober et interconnecter ;
La figure 10 sert à illustrer une technique particulière d'alignement entre deux couches d'encapsulation ;
La figure 11 sert à illustrer un mode de réalisation particulier de la couche d'encapsulation à pistes conductrices intégrées ;
La figure 12 sert à illustrer un mode de réalisation particulier des pistes conductrices intégrées à la couche d'encapsulation.

Des parties identiques, similaires ou équivalentes des différentes figures portent les mêmes références numériques de façon à faciliter le passage d'une figure à l'autre.

Les différentes parties représentées sur les figures ne le sont pas nécessairement selon une échelle uniforme, pour rendre les figures plus lisibles.

### EXPOSÉ DÉTAILLÉ DE MODES DE RÉALISATION PARTICULIERS

Un exemple de réalisation d'une structure, permettant la connexion entre des cellules photovoltaïques d'un module photovoltaïque tout en réalisant une encapsulation de ces cellules, va à présent être donné en liaison avec la figure 4.

La structure comprend une couche d'encapsulation 20 typiquement en au moins un matériau d'encapsulation à base de polymère(s). Un mode de réalisation préféré prévoit une couche d'encapsulation 20 formée de plusieurs sous-couches, une première sous-couche 22 étant à base d'au moins un premier matériau polymère, qui peut être semblable à ceux communément utilisés pour réaliser l'encapsulation de modules photovoltaïques par exemple de l'EVA (éthylène-acétate de vinyle), ou du silicone ou un thermoplastique de type polyoléfine également connu sous l'acronyme anglo-saxon TPO ou une polyoléfine réticulable, par exemple du type POE (Polyolefin Elastomer) ou d'un ionomère. Le premier polymère est prévu pour fondre au moins partiellement lors d'une étape de lamination réalisée à chaud et qui est prévue au cours du procédé de fabrication du module. La première sous-couche 22 est ici revêtue d'une deuxième sous-couche 24, dite « thermocollante », à base d'au moins un deuxième polymère doté de propriétés adhésives. Par exemple, la deuxième sous-couche 24 peut être à base de PE ou de TPU. La deuxième sous-couche 24 a une température de fusion différente de celle de la première sous-couche 22. Par exemple, le premier matériau polymère a une température de fusion située dans une première gamme, par exemple entre 60°C et 100°C, tandis que le deuxième matériau polymère a une température de fusion supérieure à celles de la première gamme et qui peut être par exemple située entre 110°C et 120°C.

La couche d'encapsulation 20 permet d'obtenir l'adhésion avec un élément de protection, typiquement une plaque de verre ou de polymère formant la face avant ou arrière d'un module tout en réalisant une encapsulation des cellules PV. Elle permet également d'assurer une isolation électrique, une barrière à l'humidité et est prévue transparente. La couche d'encapsulation est avantageusement en contact direct avec l'élément de protection et les cellules PV, sans autre couche intermédiaire.

De manière avantageuse, la couche d'encapsulation est prévue avec une épaisseur comprise entre 400 microns à 600 microns.

En variante de l'exemple illustré la couche d'encapsulation peut être formée d'un mélange du premier et deuxième polymère.

Avec une telle structure, une telle étape de lamination permet de réaliser concomitamment l'encapsulation et l'interconnexion d'un module photovoltaïque.

En effet, la couche d'encapsulation 20 a pour particularité d'être pourvue de pistes conductrices 25 intégrées qui sont destinées à être mises en contact avec des zones conductrices de cellules adjacentes ou voisines d'un module et réaliser ainsi une interconnexion entre ces cellules. Dans l'exemple de réalisation illustré sur la figure 4, les pistes conductrices 25 affleurent à la surface de la deuxième sous-couche 24. Les pistes conductrices 25 sont typiquement métalliques et formées d'un alliage fusible ou comportent un alliage fusible dont la température de fusion est de préférence inférieure à une température à laquelle l'étape de lamination à chaud est effectuée lors de la fabrication du module photovoltaïque. Cela peut permettre ainsi de mettre en œuvre une soudure lors de l'étape de lamination.

Les pistes conductrices 25 peuvent être ainsi formées ou dotées d'un matériau métallique ayant une température de fusion inférieure à 200°C et avantageusement inférieure à 170°C, température au-dessus de laquelle on évite de préférence de soumettre le module afin de ne pas le détériorer. Par exemple, les pistes conductrices 25 sont formées ou comportent un alliage à base de Bismuth et d'Indium, ces deux éléments permettant d'obtenir des alliages fusibles à basse température. L'alliage peut être en particulier choisi parmi : 93,5Sn-3Bi-3,5Ag ou 91,5Sn-5Bi-3,5Ag ou 90,5Sn-7,5Bi-2Ag ou 76Sn-22Bi-2Ag ou 42Sn-57Bi-1Ag ou 70Sn-20Bi-10ln ou 48Sn-52ln ou 50Sn-50ln ou Sn-20ln-2,8Ag, l'alliage ayant alors une température de fusion comprise entre 130°C et 140°C.

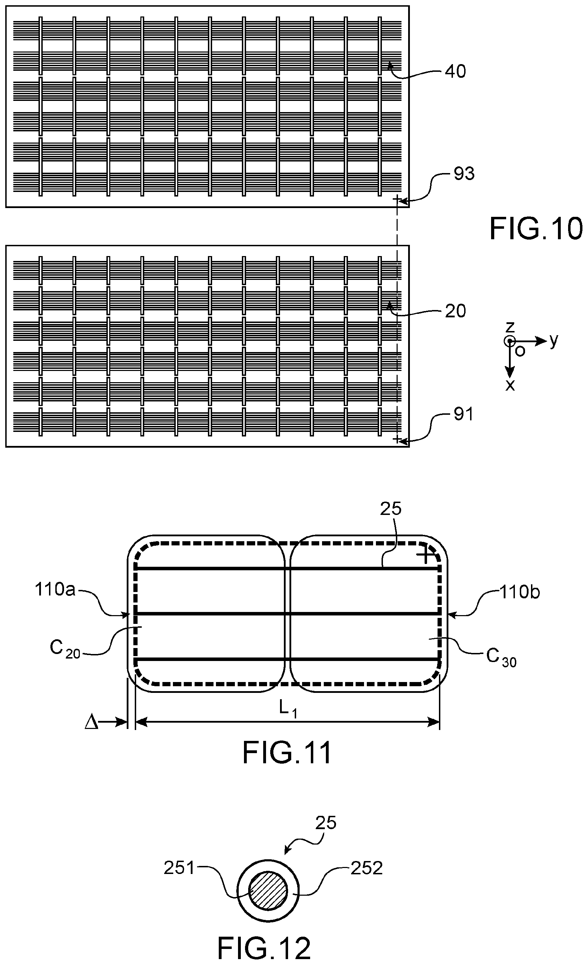

Un mode de réalisation avantageux, illustré sur la figure 12, prévoit des pistes conductrices 25 formées d'un cœur 251 en un premier matériau conducteur en particulier un matériau métallique tel que par exemple du cuivre et une enveloppe 252 autour du cœur à base d'un alliage fusible tel qu'évoqué précédemment. Le matériau à base duquel le cœur 251 est formé est dans ce cas choisi avec une température de fusion supérieure à celle du matériau de l'enveloppe 252 et en particulier supérieure aux températures utilisées lors de l'étape de lamination. Cela permet lors de l'étape de lamination de ne faire fondre que l'enveloppe 252 sans faire fondre le cœur 251.

Les pistes conductrices 25 peuvent avoir une largeur (plus petite dimension mesurée dans un plan parallèle au plan principal de la couche d'encapsulation et au plan [O ; x ; y°] du repère orthogonal [O ; x ; y°;z°]) comprise par exemple entre 50 microns jusqu'à 1 mm. Cette valeur peut être ajustée en fonction du nombre de pistes conductrices prévues sur une cellule.

Une couche d'encapsulation 20 à pistes conductrices 25 intégrées du type de celle décrite précédemment peut être réalisée de plusieurs manières.

Un exemple de réalisation prévoit la formation des pistes conductrices 25 par impression à jet d'encre en utilisant une encre conductrice 51 déposée sur une face de la couche d'encapsulation 20 (figures 5A et 5B). L'encre conductrice 51 est typiquement chargée en particules métalliques. Par exemple, une encre à base d'Ag ou de nanotubes de carbone peut être utilisée.

Dans l'exemple de réalisation illustré sur la figure 5C, les pistes conductrices 25 imprimées se présentent sous forme de portions conductrices parallèles distinctes agencées en groupes, certaines des pistes conductrices 25 étant alignées entre elles. Chaque groupe de pistes peut être prévu pour conduire un courant par exemple de l'ordre de 4 à 10 A.

Une telle technique présente pour avantage de permettre de réaliser rapidement un nombre important de pistes conductrices et de réaliser aisément une importante diversité de motifs.

Un autre exemple de technique prévoit la réalisation de la ou les pistes conductrices sous forme d'un ou plusieurs ruban(s) ou de fil(s) conducteur(s) que l'on dispose en surface ou que l'on intègre dans la couche d'encapsulation.

On peut également prévoir de partir d'une structure comportant une ou plusieurs pistes conductrices déjà intégrées à ou sur un matériau polymère, à laquelle on adjoint un ou plusieurs autres matériau(x) polymère(s), en particulier au moins polymère adhésif, pour compléter la formation de la couche d'encapsulation. Comme indiqué plus haut, cette couche d'encapsulation remplit alors à la fois la fonction d'un support pour l'interconnexion et une fonction d'encapsulation afin de protéger les cellules photovoltaïques de l'environnement.

L'agencement des pistes conductrices 25 sur la couche d'encapsulation 20 est prévu notamment en fonction de celui de zones conductrices agencées sur les faces avant ou arrière de cellules que la structure d'interconnexion est destinée à connecter. Il peut être adapté en fonction de la taille des cellules voisines ou adjacentes.

L'agencement des pistes peut différer suivant que la structure d'interconnexion est prévue pour connecter entre elles les faces inférieures de cellules solaires adjacentes ou bien connecter entre elles les faces supérieures de cellules solaires voisines.

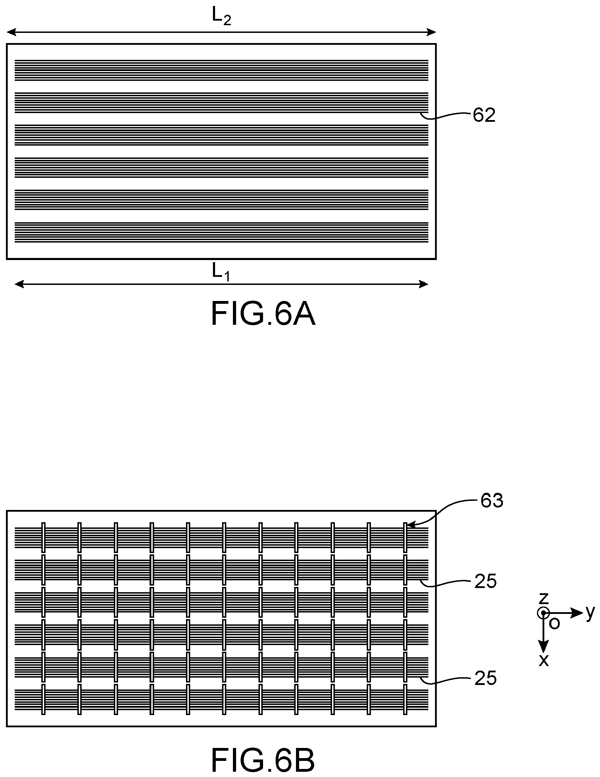

Une variante particulière du procédé de fabrication d'une couche d'encapsulation à pistes conductrices intégrées est illustrée sur les figures 6A-6B.

Elle comprend la formation de pistes sous forme de lignes conductrices 62 parallèles entre elles qui peuvent être imprimées ou déposées sous forme de fils conducteurs ou de rubans conducteurs sur une couche de matériau polymère flexible (figure 6A) par exemple selon une technique dite de rouleau à rouleau (« roll to roll » selon la terminologie anglo-saxonne). Des fils conducteurs en Cuivre de diamètre compris entre 150 et 300 µm, en particulier entre 200 et 250 µm et de longueur de l'ordre de plusieurs dizaines de cm peuvent être par exemple utilisés.

Les lignes conductrices 62 s'étendent typiquement sur une longueur L₁ légèrement inférieure à la longueur L₂ de la couche de matériau polymère flexible. Par exemple, lorsqu'on prévoit une couche d'encapsulation de longueur L2 de l'ordre de 2050 mm la longueur L1 des lignes conductrices peut être prévue égale de l'ordre de 2015 mm

Puis, des tranchées 63 ou creux de séparation sont effectué(e)s pour former à partir de ces lignes conductrices (figure 6B) une succession de tronçons conducteurs disjoints et déconnectés entre eux. Les tranchées 63 ou creux de séparation peuvent être prévu(e)s avec une largeur qui peut être comprise entre 500 µm et plusieurs millimètres, par exemple entre 1 mm et 3 mm. Une telle découpe en tronçons conducteurs peut être effectuée par poinçonnement de la couche d'encapsulation 20.

Après la séparation éventuelle en tronçons conducteurs, on peut prévoir de compléter la formation de la structure d'interconnexion en ajoutant localement des zones conductrices supplémentaires, par dépôt ou bien par impression jet d'encre.

La fabrication de la couche d'encapsulation avec ses pistes conductrices peut être réalisée de manière indépendante de celle d'un module photovoltaïque dans lequel une telle couche est destinée à être intégrée. Ainsi, le lieu de fabrication de la couche d'encapsulation avec ses pistes conductrices intégrées peut être différent de celui de fabrication du module photovoltaïque.

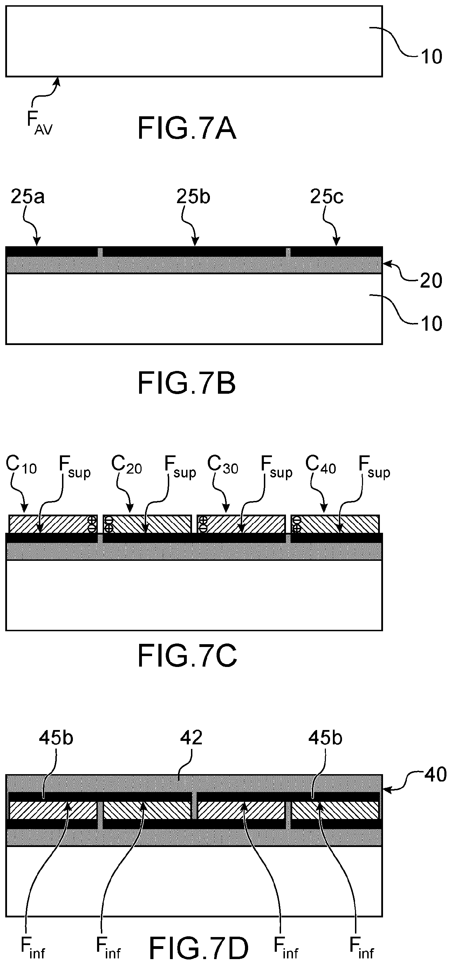

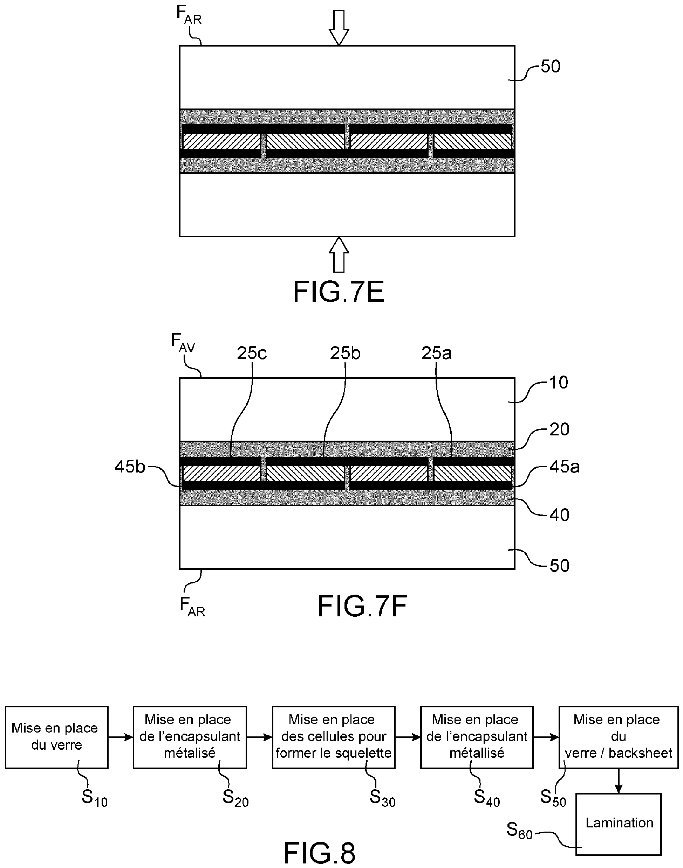

Un exemple particulier de procédé de fabrication d'un module photovoltaïque va à présent être décrit en liaison avec les figures 7A-7F.

Le matériau de départ (figure 7A) de ce procédé est ici un premier élément de protection destiné à former une face du module photovoltaïque, par exemple sa face avant F_{AV}. Le premier élément est typiquement sous forme d'une couche ou d'une plaque 10, en polymère ou en verre. La plaque 10 est prévue transparente au rayonnement solaire.

On dispose ensuite sur cette plaque 10, une couche d'encapsulation 20 telle que décrite précédemment et munie de pistes conductrices intégrées 25a, 25b, 25c (figure 7B). Comme on peut le voir sur la figure 7B, la couche d'encapsulation 20 est placée en contact direct sur la plaque 10, sans qu'il y ait de couche supplémentaire intermédiaire.

Puis, on dispose des cellules photovoltaïques C₁₀, C₂₀, C₃₀, C₄₀ en contact avec la couche d'encapsulation 20, en particulier sur cette couche d'encapsulation 20 (figure 7C). Les pistes conductrices 25a, 25b, 25c sont ici prévues pour réaliser une connexion entre des zones conductrices (non représentées) des faces que l'on appellera « supérieures » Fsup respectives de cellules photovoltaïques adjacentes ou voisines juxtaposées.

L'ensemble de cellules C₁₀, C₂₀, C₃₀, C₄₀ est typiquement formé d'une alternance de cellules C₁₀, C₃₀ ayant une première polarité au niveau de leur face supérieure et de cellules C₂₀, C₄₀ ayant, au niveau de leur face supérieure, une polarité opposée à la polarité des cellules C₁₀, C₃₀. Les cellules C₁₀, C₂₀, C₃₀, C₄₀ peuvent être en particulier des cellules, par exemple à base de silicium et plus particulièrement de type à hétérojonction, et dont la face avant ainsi que la face arrière sont toutes les deux actives (cellules bifaciales). Dans ce cas, la face supérieure Fsup des cellules C₁₀, C₃₀ peut correspondre par exemple à leur face avant avec une polarité donnée, dans l'exemple illustré négative tandis que la face supérieure Fsup des cellules C₂₀, C₄₀ peut correspondre par exemple à leur face arrière de polarité opposée à la polarité donnée, dans l'exemple illustré positive. Les cellules C₂₀, C₄₀, peuvent être ainsi des cellules semblables aux cellules C₁₀, C₃₀, mais retournées par rapport aux cellules C₁₀, C₃₀.

Puis, on dispose sur cet ensemble de cellules photovoltaïques C₁₀, C₂₀, C₃₀, C₄₀ une autre couche d'encapsulation 40 également pourvue de pistes conductrices 45a, 45b intégrées (figure 7D). Ces pistes conductrices 45a, 45b sont cette fois prévues pour réaliser une connexion entre des zones conductrices des faces dites « inférieures Finf » respectives de cellules photovoltaïques adjacentes ou voisines juxtaposées. La couche d'encapsulation 40 peut avoir une constitution semblable à celle de la couche d'encapsulation 20 déjà déposée, mais avec une disposition différente de ses pistes conductrices 45a, 45b. Ainsi, la couche d'encapsulation 40 peut être formée d'un ou plusieurs matériaux polymères sur lequel on a rapporté ou imprimé des pistes en matériau métallique ou en alliage de matériaux métalliques.

Les pistes conductrices 45a, 45b de la couche d'encapsulation 40 sont ici prévues pour réaliser une connexion entre des zones conductrices des faces inférieures F_{inf} respectives de cellules photovoltaïques adjacentes C₁₀ et C₂₀, C₃₀ et C₄₀ ou voisines juxtaposées.

Une fois l'autre couche d'encapsulation 40 disposée sur l'empilement, on met en place un élément de protection destiné à former la face arrière du module photovoltaïque. Cet élément de protection est typiquement sous forme d'une couche ou d'une plaque 50, en polymère ou en verre. La plaque 50 peut être éventuellement prévue transparente au rayonnement solaire en particulier lorsque les cellules sont pourvues d'une couche active ou d'un absorbeur en face arrière. L'élément de protection est ici également placé en contact direct avec l'autre couche d'encapsulation 40. Ainsi, de manière avantageuse, on ne prévoit pas de couche intermédiaire entre l'élément de protection et l'autre couche d'encapsulation 40.

On effectue ensuite la lamination à chaud entre la plaque 10 et la plaque 50, d'un empilement comprenant les cellule photovoltaïque C10, C20, C30, C40 juxtaposées recouvertes par les couches d'encapsulation 20, 40, de sorte à faire fondre au moins partiellement le ou les matériau polymère de ces couches d'encapsulation, afin de réaliser un enrobage de l'ensemble de cellules. La couche d'encapsulation 20 permet de réaliser l'adhésion avec l'élément de protection, ici sous forme d'une plaque 10. De même, la lamination est mise en œuvre de sorte que l'autre couche d'encapsulation 40 adhère à l'autre élément de protection, ici sous forme d'une plaque 50.

Pendant cette lamination à chaud, le matériau conducteur à base duquel les pistes conductrices 45a, 45b est également au moins partiellement fondu de sorte à pouvoir réaliser un contact avec des zones conductrices des cellules.

La lamination peut comprendre une étape de mise sous vide pendant durée donnée, suivie d'une étape de chauffe durant laquelle on applique une pression (figure 7E) positive comprise par exemple entre 100 mbar et 1 bar, préférentiellement entre 500 mbar et 1 bar, voire 800 mbar et 1 bar. Comme évoqué précédemment, la température et la durée nécessaires dépendent notamment des caractéristiques des matériaux polymères des couches d'encapsulation 20, 40 et du ou des matériaux des pistes conductrices intégrées dans ces couches. Par exemple, pour on peut effectuer un traitement thermique à une température comprise entre 140 et 170°C pendant une durée comprise entre 10 et 20 minutes.

L'organigramme séquentiel de la figure 8 donne un exemple d'enchainement d'étapes S₁₀, S₂₀, S₃₀, S₄₀, S₅₀, S₆₀ d'un procédé suivant l'invention pour réaliser un module solaire.

L'utilisation de couches d'encapsulation à pistes conductrices intégrées (« encapsulant métallisé ») aux étapes S20, S40 permet de réaliser une interconnexion et un enrobage des cellules de manière concomitante. On diminue ainsi le nombre global d'étapes par rapport à un procédé conventionnel.

Un nouvel enchainement d'étapes (« process flow ») pour la fabrication de modules est obtenu et l'utilisation d'appareils de type préhension et placement (« pick and place ») peut remplacer pour certaines étapes l'utilisation d'appareils de type « stringer ».

Pour permettre de rendre plus précis le positionnement des cellules photovoltaïques à l'étape S30 par rapport à la couche d'encapsulation inférieure, ou à l'étape S40 par rapport à la couche d'encapsulation supérieure, ces couches d'encapsulation 20, 40 peuvent être pourvues d'au moins une marque d'alignement, par exemple réalisée par impression d'un motif sur le matériau polymère de la couche d'encapsulation.

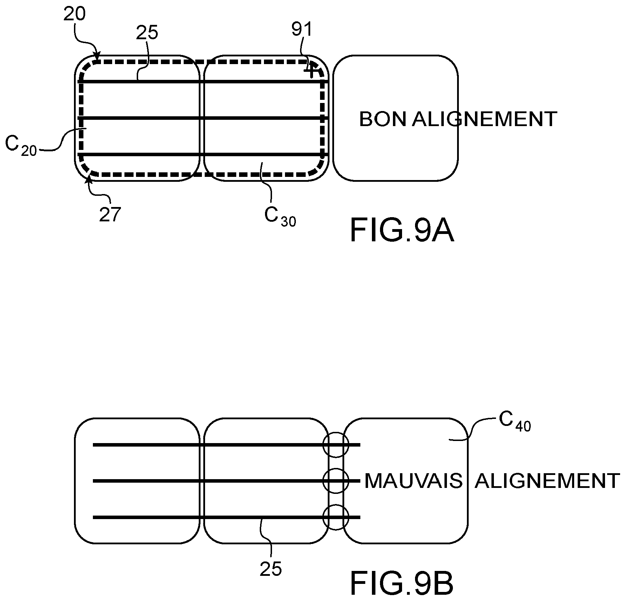

Une couche d'encapsulation 20 munie d'une telle marque d'alignement 91 est représentée de manière schématique sur la figure 9A, pour permettre le positionnement précis des pistes conductrices 25 de la couche d'encapsulation 20 en regard de deux cellules C20, C30 et de leurs zones de connexion (non représentées).

Une telle marque 91 peut être détectée par un élément de détection muni par exemple d'une caméra d'un dispositif de préhension et placement (« pick and place ») configuré pour positionner un ensemble de cellules solaires par rapport à l'empilement déjà réalisé du module et/ou pour positionner une couche d'encapsulation 25 par rapport à un ensemble de cellules solaires. On évite ainsi un mauvais alignement de l'encapsulation et par exemple un dépassement des pistes 25 tel qu'illustré sur la figure 9B en regard d'une autre cellule C₄₀.

Dans l'exemple de réalisation particulier illustré sur la figure 10, un alignement est cette fois réalisé entre une marque 91 de positionnement d'une couche d'encapsulation inférieure 20 et un marque 93 de positionnement d'une couche d'encapsulation supérieure 40 disposées de part et d'autre d'un ensemble de cellules (non représenté) pour former un empilement destiné à subir l'étape de lamination à chaud.

Pour éviter un mauvais positionnement des pistes conductrices 25 et éviter la création de dérivations (« shunts ») ou court-circuit, on fait typiquement en sorte, comme sur la figure 11, de prévoir une longueur L1 de pistes inférieure à la longueur cumulée de deux cellules juxtaposées C20, C30, et de conserver un espacement Δ entre les extrémités des pistes conductrices 25 et des bords externes 110a, 110b des cellules C20, C30 en regard desquelles la couche d'encapsulation 20 est située.

## Revendications

1. Procédé de fabrication d'un module photovoltaïque, comprenant au moins une première cellule photovoltaïque (C₂₀) et au moins une deuxième cellule photovoltaïque (C₃₀) chacune dotée d'une face inférieure (F_{inf}) et d'une face supérieure (Fₛᵤₚ) opposée à la face inférieure, la première cellule et la deuxième cellule étant connectées entre elles et disposées entre un premier élément (10) de protection, en particulier une première plaque, formant une face arrière (F_{AR}) du module photovoltaïque, et un deuxième élément (50) de protection, en particulier une deuxième plaque, transparent(e) et formant une face avant (F_{AV}) du module photovoltaïque,
le procédé comprenant des étapes de :
- placement en contact direct avec le premier élément (10) de protection d'une première couche d'encapsulation (20) à base d'au moins un matériau polymère d'encapsulation en contact avec les faces inférieures respectives de la première cellule photovoltaïque (C₂₀) et de ladite deuxième cellule photovoltaïque (C₃₀) juxtaposées, la première couche d'encapsulation étant formée d'au moins un matériau d'encapsulation polymère intégrant une ou plusieurs pistes conductrices (25, 25a, 25b, 25c, 45a, 45b) à base d'au moins un matériau conducteur donné, lesdites pistes conductrices étant agencés sur des régions conductrices respectivement de la première cellule et de la deuxième cellule,
- formation, sur la face supérieure (Fsup) de ladite première cellule photovoltaïque (C₂₀) et de ladite deuxième cellule photovoltaïque (C₂₀) juxtaposées, d'une deuxième couche d'encapsulation (40) munie d'autres pistes conductrices (45a, 45b) intégrées,
- lamination à chaud entre le premier élément (10) de protection et le deuxième élément (50) de protection, d'un empilement comprenant ladite première cellule photovoltaïque (C₂₀) et ladite deuxième cellule photovoltaïque (C₃₀) juxtaposées recouvertes par ladite première couche d'encapsulation (20, 40), de sorte à faire fondre au moins partiellement ledit matériau polymère d'encapsulation et ledit matériau conducteur donné et réaliser un enrobage de ladite première cellule et de ladite deuxième cellule par ledit matériau polymère d'encapsulation tout en réalisant une connexion entre la première cellule et la deuxième cellule par l'intermédiaire desdites pistes conductrices, ladite lamination à chaud étant réalisée de sorte à faire fondre en outre concomitamment ladite deuxième couche d'encapsulation (40) et réaliser une connexion entre la face supérieure (Fsup) de la première cellule et la face supérieure de la deuxième cellule par l'intermédiaire desdites autres pistes conductrices (45a, 45b), tout en faisant adhérer la première couche d'encapsulation avec le premier élément (10) de protection.

2. Procédé selon la revendication 1, dans lequel les pistes conductrices comportent un matériau conducteur donné ayant une température de fusion inférieure à une température à laquelle la lamination à chaud est effectuée, la température à laquelle la lamination à chaud est effectuée étant comprise entre 120 et 170°C, de préférence entre 140 et 170°C.

3. Procédé selon l'une des revendications 1 ou 2, dans lequel les pistes conductrices (25) comportent une enveloppe (252) à base dudit matériau conducteur donné et un cœur (251) à base d'un autre matériau conducteur ayant une température de fusion supérieure à celle à laquelle la lamination à chaud est effectuée.

4. Procédé selon l'une des revendications 1 à 3, dans lequel la couche d'encapsulation (25, 45) est formée d'au moins un polymère ayant des propriétés adhésives, tel que du PE ou du TPU.

5. Procédé selon la revendication 4, dans lequel la couche d'encapsulation (25, 45) est formée d'au moins un autre matériau polymère choisi parmi les polymères suivants : EVA (éthylène-acétate de vinyle), silicone, TPO, POE, ou d'un ionomère.

6. Procédé selon l'une des revendications 1 à 5, dans lequel la couche d'encapsulation (20, 40) comporte au moins une première marque d'alignement (91, 93).

7. Procédé selon la revendication 6, dans lequel le procédé comprend le placement d'une deuxième couche d'encapsulation (45) disposée sur la face supérieure de ladite première cellule photovoltaïque (C20) et de ladite deuxième cellule photovoltaïque (C20) et dans lequel la deuxième couche d'encapsulation (45) comporte une marque d'alignement (93) dite « deuxième marque d'alignement »,
le placement de ladite deuxième couche d'encapsulation étant effectué par un dispositif de préhension et placement muni d'un élément de détection tel qu'une caméra, pour détecter ladite première marque d'alignement (91) et disposer ladite deuxième marque d'alignement (93) en regard de ladite première marque d'alignement (91).

8. Procédé selon l'une des revendications 1 à 7, dans lequel la ou les pistes conductrices (25a, 25b 25c, 45a, 45b) de ladite couche d'encapsulation (20, 40) sont des pistes imprimées d'encre conductrice.

9. Procédé selon l'une des revendications 1 à 8, comprenant en outre préalablement au placement de la couche d'encapsulation : la fabrication de ladite couche d'encapsulation, cette fabrication comprenant au moins une étape de dépôt de fils ou rubans conducteurs ou d'impression de lignes d'encre conductrice sur une couche du matériau polymère d'encapsulation pour réaliser lesdites pistes conductrices (25a, 25b, 25c, 45a, 45b).

10. Procédé selon la revendication 9, dans lequel ladite fabrication de ladite couche d'encapsulation comprend une étape de séparation par poinçonnement de portions des fils conducteurs ou rubans conducteurs ou lignes conductrices.

11. Procédé selon l'une des revendications 1 à 10, les faces inférieure et supérieure de la première cellule photovoltaïque (C₂₀) ayant des polarités opposées respectivement à la face inférieure et à la face supérieure de ladite deuxième cellule photovoltaïque (C₃₀).
